# EUROPEAN PATENT SPECIFICATION

(11) **EP 3 719 842 B1**
(45) Date of publication and mention of the grant of the patent: **27.09.2023**
(21) Application number: 19166514.0
(22) Date of filing: 01.04.2019
(51) Int. Cl.: H01L 27/146

(54) **4T PIXEL AND IMAGE SENSOR COMPRISING THE SAME**
4T-PIXEL UND BILDSENSOR DAMIT
PIXEL 4T ET CAPTEUR D'IMAGE LE COMPRENANT

(43) Date of publication of application: 07.10.2020
(73) Proprietor: Teledyne Dalsa B.V., 5656 AE Eindhoven (NL)
(72) Inventor: Maes, Willem Hendrik, 3920 Lommel (BE)
(74) Representative: Jacobs, Bart

(56) References cited:
- WO-A1-2014/059920
- US-A1- 2006 186 505
- US-A1- 2016 286 151
- US-A1- 2016 307 947

## Description

The present invention relates to a 4T pixel and to an image sensor comprising the same. Such a pixel may for example be used for optical imaging and/or X-ray imaging. The invention particularly relates to 4T pixels and image sensors based on complementary metal-oxide-semiconductor (CMOS) technologies.

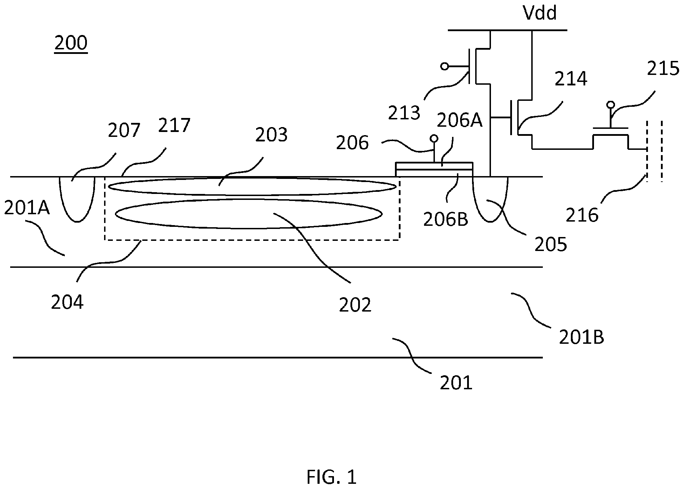

4T pixels are well known in the art. An example of a 4T pixel is schematically illustrated in figure 1. Here, it is noted that the figure is not true to scale.

The known 4T pixel 200 comprises a substrate 201 in which a storage well 202, a pinning layer 203, and a floating diffusion 205 are arranged. Substrate 201 is embodied as a bulk semiconductor substrate 201B, such as Silicon, on which one or more epitaxial layers 201A are arranged. Typically, the one or more epitaxial layers 201A and/or substrate 201B are lightly doped. In the embodiment of figure 1, epitaxial layer(s) 201A are p-type doped.

Storage well 202, pinning layer 203, and a part of substrate 201 that is adjacent to storage well 202 form a pinned photodiode 204. Moreover, floating diffusion 205 is arranged spaced apart from pinned photodiode 204.

Floating diffusion 205 is connected to a reset transistor 213. In figure 1, reset transistor 213 is embodied as an NMOS transistor having its drain connected to a supply voltage Vdd and its source to floating diffusion 205. The gate terminal of reset transistor 213 is configured to receive a RESET control signal by which reset transistor 213 can be controlled. More in particular, when a logical high signal is received at the gate terminal, floating diffusion 205 will be connected to Vdd thereby resetting the voltage at floating diffusion 205.

Floating diffusion 205 is further connected to a source follower 214 which is embodied as an NMOS transistor and which transfers the voltage at floating diffusion 205 to the drain terminal of a select transistor 215. This latter transistor is also embodied as an NMOS transistor. The source terminal of select transistor 215 is connected to a column bus 216. If a logical high signal is received at the gate terminal of select transistor 215, the voltage at floating diffusion 205 will be put onto column bus 216.

An image sensor typically comprises a plurality of pixels arranged in a matrix having rows and columns. The pixels in each row are typically provided with the same logical RESET and SELECT control signals in the sense that each pixel in a given row is selected and reset at substantially the same time. Pixels in the same column are connected to one and the same column bus. Hence, if the matrix comprises n rows and m column, the image sensor may use n reset control lines, n select control lines, and m column busses. It should be noted that some image sensors comprise additional logical control lines and/or dummy pixels for calibration purposes.

In view of the above, when a row of pixels is selected, the voltages of the respective floating diffusions 205 will be put on respective column busses 216. Suitable read-out circuitry is provided to convert these voltages in a suitable signal that can be processed into an image. The image sensor further comprises control circuitry to provide the SELECT and RESET control signals. Typically, the control circuitry comprises a shift register for sequentially selecting one or more rows.

Typically, storage well 202 and pinning layer 203 are doped with dopants of opposite types. Furthermore, pinning layer 203 and epitaxial layer(s) 201A and/or substrate 201B are doped with dopants of similar type. For example, pinning layer 203 may be p++-type doped, storage well 202 n-type doped, and epitaxial layer(s) 201A p-type doped.

Pixel 200 is configured such that under equilibrium conditions storage well 202 is completely depleted. When light falls onto pixel 200 electron-hole pairs will be generated. Under the influence of the electric fields in the depletion region in storage well 202, the generated electron-hole pairs will be separated and electrons will accumulate in storage well 202.

A transfer gate 206 is arranged in between pinned photodiode 204 and floating diffusion 205. This gate can be embodied as a MOS capacitor. For example, transfer gate 206 comprises an oxide layer 206B on which a polysilicon gate 206A is arranged. Substrate 201, having a p-type doping, extends directly underneath oxide layer 206B. When a high logical signal is received at transfer gate 206, a conduction channel potential is created underneath oxide layer 206B. This channel allows the electrons in storage well 202 to move from storage well 202 to floating diffusion 205, which is at a higher potential.

A predetermined amount of time, referred to as transfer time, after having activated transfer gate 206, transfer gate 206 will be closed and select transistor 215 will be activated. Due to the collection of electrons in floating diffusion 205, the voltage thereof is reduced. This reduced voltage is put onto column bus 216 via source follower 214 and select transistor 215.

After the voltage of floating diffusion 205 has been put on column bus 216, select transistor 215 will be closed and reset transistor 213 will be activated allowing the voltage of floating diffusion 205 to be reset. Hereafter, the process can be repeated.

4T pixels offer the possibility of using other read-out techniques, such as correlated double sampling (CDS), by which the impact of process variation on the final image can be eliminated.

Image sensors can be characterized by several figures of merit. One of those figures is the read-out time, i.e. the time that is required to read-out the entire matrix of pixels. This figure of merit determines for example the frames-per-second read-out capability of the sensor. An important factor that determines this figure of merit is the time that is required for completing the charge transfer process of the electrons moving from storage well 202 to floating diffusion 205. The fact that this time is non-zero is often described as one contribution to the pixel having a particular lag. If the transfer time is selected to be too low, too much electrons will remain in storage well 202 causing loss of dynamic range of the sensor. If the transfer time is selected to be too high, a reduction in frames-per-second will occur.

A pixel as defined by the preamble of claim 1 is known from US 2006/186505 A1.

An object of the present invention is to provide a 4T pixel having a reduced lag. This object is achieved with the pixel of claim 1 that is characterized in that the pixel is a 4T pixel and in that the pinning layer is electrically isolated from the substrate using an isolation gate that surrounds the pinning layer.

The Applicant has found that by putting the pinning layer at a predefined voltage, the voltage difference between the storage well and the floating diffusion can be increased. Such an increased voltage is accompanied by higher electrical fields which cause the electrons to be transferred to the floating diffusion more rapidly thereby reducing lag. Such voltage may only be applied to the pinning layer if this layer is electrically isolated from the substrate. If such isolation is not present, large leakage currents will flow between the first contact and the substrate, which is most often grounded.

The 4T pixel may further comprise a diffusion region arranged spaced apart from the pinning layer, wherein the isolation gate is arranged in between the diffusion region and the pinning layer. The isolation gate can be embodied as a MOS capacitor comprising an oxide layer arranged on the substrate and a conductive electrode, such as a polysilicon layer, arranged on the oxide layer. By applying a suitable voltage, the region underneath the oxide layer can be depleted thereby preventing electrical contact between the pinning layer and the substrate. More in particular, a depletion region in between the diffusion region and pinning layer can be generated that prevents electrical contact between the substrate and pinning layer. The pixel may have an electrical contact to the diffusion region, for example an ohmic contact, to bias the diffusion region, optionally independently from biasing the isolation gate. As an example, the diffusion region is connected to a supply voltage.

A doping type of the diffusion region can be different from a doping type of the pinning layer. For example, the pinning layer and the substrate may doped using one of p-type dopants and n-type dopants, and the storage well, floating diffusion and diffusion region can be doped using the other of p-type dopants and n-type dopants. For example, the substrate and pinning layer can be p-type doped. The substrate may comprise a bulk semiconductor substrate and an epitaxial layer, wherein a doping type of the epitaxial layer is identical to the doping type of the pinning layer.

The pinning layer may extend laterally beyond the storage well. Furthermore, the pinning layer may comprise an outer perimeter and an inner perimeter, wherein the inner perimeter defines an inner space in which the transfer gate and floating diffusion are arranged, and wherein the isolation gate or isolating diffusion completely surrounds the outer perimeter.

By splitting the electron transfer functionality realized by the transfer gate and the isolation functionality realized by the isolation gate or isolating diffusion on different perimeters, problems associated with close proximity of transfer gates on the one hand and isolation gates or isolating diffusions on the other hand can be prevented. Preferably, the transfer gate is arranged along the entire inner perimeter and the isolating diffusion or isolation gate along the entire outer perimeter.

The first contact may form an ohmic contact to the pinning layer. Alternatively, the first contact may form a Schottky contact to the pinning layer. In both cases, the voltage applied to the first contact should be such that electrons are pushed towards the floating diffusion. The first voltage is preferably applied only during the transfer time.

The substrate may comprise an upper surface on which the transfer gate and first contact are arranged. The 4T pixel may further comprise a scintillator layer arranged on the top surface of the substrate for converting incoming X-rays into visible light. This allows the pixel to be used for X-ray imaging.

The 4T pixel may further comprise a reset transistor for resetting a voltage of the floating diffusion, a source follower connected to the floating diffusion, and a select transistor arranged to selectively connect an output of the source follower to a column bus. Preferably, the reset transistor, select transistor and source follower are arranged within the abovementioned inner space as defined by the inner perimeter.

At least one but preferably all of the reset transistor, source follower, and select transistor, are formed using MOS transistors.

According to a second aspect, the present invention provides an image sensor comprising a 4T pixel as defined above and a controller for controlling the reset transistor and the select transistor, and configured for applying a voltage to the first contact. According to the invention, the controller is configured to control the reset transistor to reset a voltage of the floating diffusion, to control the transfer gate to allow charges in the storage well to transfer to the floating diffusion, and to control the select transistor to allow a voltage of the floating diffusion to be read out via the column bus, and to apply a voltage to the first contact during at least part of said transfer of charges.

The controller may be further configured to control the select transistor, transfer gate and reset transistor to implement correlated double sampling. Additionally or alternatively, the image sensor may comprise a plurality of said pixels arranged in a matrix of rows and columns, wherein pixels in the same column share the same column bus and wherein pixels in the same row are simultaneously controlled by the controller. The image sensor may further comprise read-out circuitry for simultaneously collecting outputs from the plurality of column busses.

The controller can be configured to operate the isolation gate in an isolating mode in which mode the voltage applied to the isolation gate results in a depletion region to be formed between the pinning layer and the substrate. Additionally, the controller may be configured to operate the isolation gate in an overflow mode in which mode the voltage applied to the isolation gate allows electrical contact between the storage well and the diffusion region depending on the filling of the pixel and the applied voltage on the isolation gate. In this manner, the charge collection process in the storage well may be influenced during the time that electron-hole pairs are generated as a result of incoming light.

Next, the invention will be described in more detail referring to the appended drawings, wherein:
Figure 1 illustrates a known 4T pixel;
Figure 2 illustrates an embodiment of a 4T pixel in accordance with the present invention;
Figure 3 illustrates another embodiment of a 4T pixel in accordance with the present invention;
Figure 4 illustrates a possible layout in top view of a 4T pixel in accordance with the present invention;
Figure 5 illustrates an embodiment of an image sensor in accordance with the present invention;
Figure 6 illustrates the energy profile of electrons during the transfer time; and
Figure 7 illustrates the lag associated with the transfer of electrons as a function of the first voltage and transfer gate voltage.

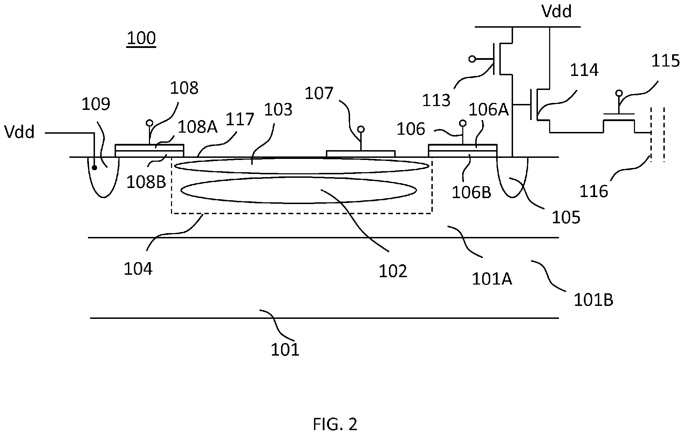

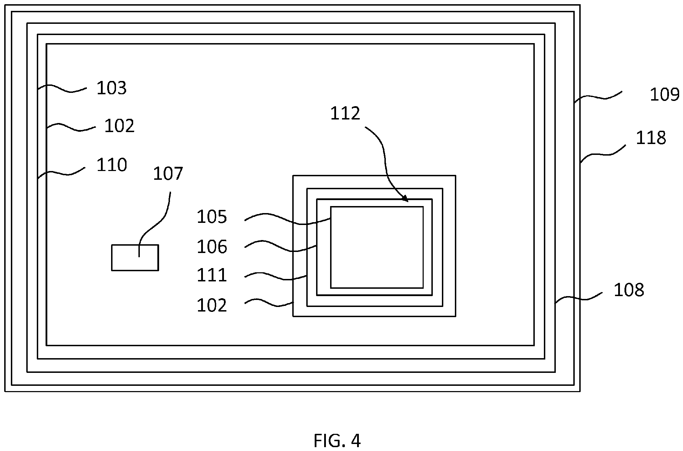

Figure 2 illustrates an embodiment of a 4T pixel in accordance with the present invention, and figure 4 illustrates a possible layout of this pixel. Similar to the 4T pixel shown in figure 1, 4T pixel 100 comprises a substrate 101 in which a storage well 102, a pinning layer 103, and a floating diffusion 105 are arranged. Substrate 101 is embodied as a bulk semiconductor substrate 101B, such as Silicon, on which one or more epitaxial layers 101A are arranged. Here, epitaxial layer(s) 101A are p-type doped. Storage well 102, pinning layer 103, and a part of substrate 101 that is adjacent to storage well form a pinned photodiode 104. Moreover, floating diffusion 105 is arranged spaced apart from pinned photodiode 104.

Floating diffusion 105 is connected to a reset transistor 113 and is further connected to a source follower 114 which transfers the voltage at floating diffusion 105 to the drain terminal of a select transistor 115. The source terminal of select transistor 115 is connected to a column bus 116. Select transistor 115, source follower 114, and reset transistor 113 are all embodied as NMOS transistors.

The working principles of the components mentioned so far correspond to those described in conjunction with figure 1.

However, when comparing the 4T pixel of figure 2 to the 4T pixel of figure 1, differences can be observed. Firstly, an isolation is created between pinning layer 103 and substrate 101 using a diffusion region 109 and an isolation gate 108 arranged in between pinning layer 103 and diffusion region 109. In figure 2, a p-type doping is used for substrate 101 and pinning layer 103, and an n-type doping is used for floating diffusion 105, storage well 102, and diffusion region 109.

Diffusion region 109 is electrically connected to supply voltage Vdd or another suitable voltage source. To this end, diffusion region 109 may be contacted using an ohmic contact (not shown). When a sufficiently high voltage is applied to isolation gate 108, a depletion region is formed underneath isolation gate 108 such that electrical contact between pinning layer 103 and substrate 101 is prevented.

Isolation gate 108 can be formed using a MOS transistor. It may for example comprise an oxide layer 108B on which a polysilicon layer 108A is arranged. It should be further noted that it is also possible to control the voltage applied to diffusion region 109 and isolation gate 108 separately and individually. For example, applying a suitable voltage to isolation gate 108 causes a strong depletion region to be formed blocking electrical contact between pinning layer 103 and substrate 101. Such operation can be referred to as isolating mode. In another mode, referred to as overflow mode, the voltage applied to isolation gate 108 enables a channel potential to be formed underneath isolation gate 108. Electrons in storage well 102 may then be transferred to diffusion region 109. More in particular, the extent to which the electrons are transferred can be controlled by controlling the voltage applied to isolation gate 108. It should be noted that further control is possible by also controlling the voltage applied to diffusion region 109.

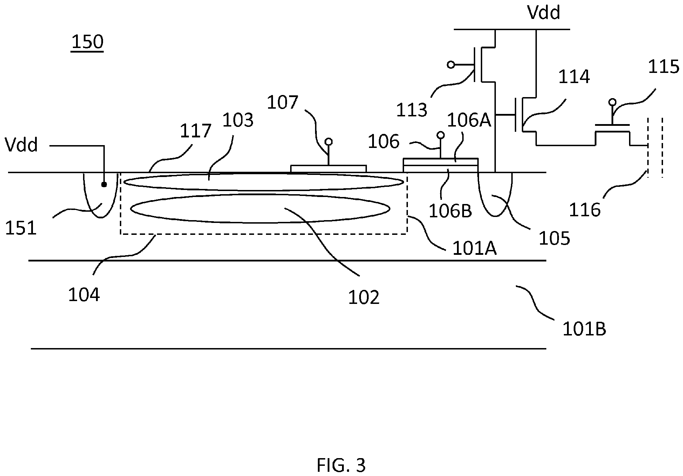

The isolation between pinning layer 103 and substrate 101 can also be achieved in a different manner. For example, the 4T pixel 150 in figure 3 comprises an isolating diffusion 151 that is arranged in close vicinity of pinning layer 103 and spaced apart from storage well 102. Isolating diffusion 151 has a different doping type than substrate 101 and pinning layer 103. Consequently, a depletion region is formed between pinning layer 103 and substrate 101 such that large currents between pinning layer 103 and substrate 101 are avoided.

Figure 4 illustrates a possible layout in top view of a 4T pixel in accordance with the present invention. This layout corresponds to the 4T pixel shown in figure 2. However, a similar layout would be possible for the 4T pixel of figure 3 with the exception that isolation gate 108 and diffusion 109 would be replaced by an isolating diffusion 151.

As illustrated, pinning layer 103 comprises an outer perimeter 110 and an inner perimeter 111. Furthermore, a scintillator layer 118 is shown that converts incoming X-ray photons into visible light photons allowing the 4T pixel to be used in an X-ray detector. This layer is optional as it can be omitted in the 4T pixel is used for regular optical detectors.

Isolation between pinning layer 103 and substrate 101 is required on both outer perimeter 110 and inner perimeter 111. On outer perimeter 110, isolation is achieved using isolation gate 108 and diffusion 109 that are both surrounding pinning layer 103. On inner perimeter 111, isolation is achieved using transfer gate 106 and floating diffusion 105.

At least during the transfer time, pinning layer 103 can biased using first contact 107 which can be arbitrarily arranged in between inner perimeter 111 and outer perimeter 110.

Also illustrated is inner space 112 in which the various transistors are arranged required for selecting and resetting the pixel. Contact to these transistors is made possible using narrow control lines that pass over pinning layer 103. Similarly, first contact 107 to pinning layer 103 and transfer gate 106 can be provided with suitable signals via separate control lines.

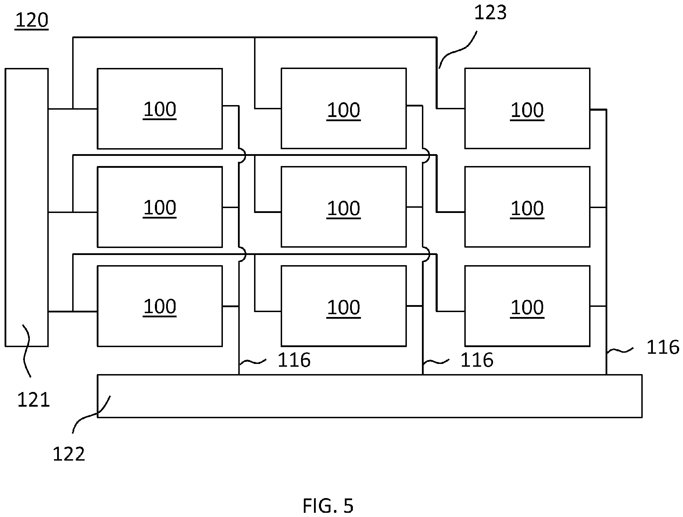

Figure 5 illustrates an embodiment of an image sensor 120 in accordance with the present invention. As shown, image sensor 120 comprises a plurality of 4T pixels 100, although 4T pixels 150 of figure 3 could equally be used. Each pixel 100 is connected by means of control lines to a controller 121. Here, the multiple control lines are collectively represented by control line 123.

Controller 121 is configured to sequentially select a row of 4T pixels 100 for read out, and to reset one or more rows of 4T pixels 100. Furthermore, controller 121 is configured to provide the bias signal to be applied to first contact 107 and the control signal to be applied to transfer gate 106. In addition, controller 121 may be configured to provide control and/or bias signals to diffusion region 109 and isolation gate 108.

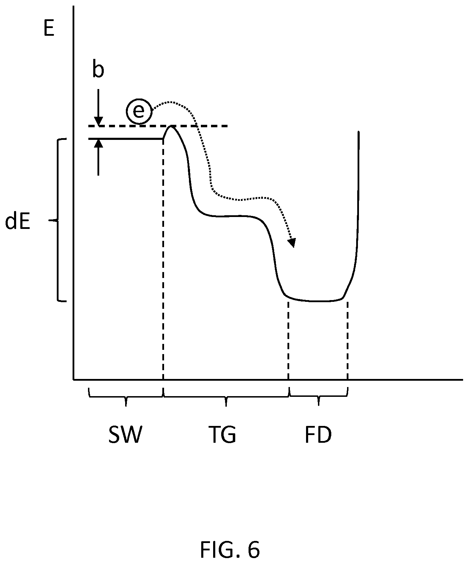

Next, referring to figures 2 and 6, a typical read out process will be described which is known as a correlated double sampling technique.

As a first step, a row of pixels is reset by controller 121 by providing a logical high to reset transistor 113 and transfer gate 106, while providing a logical low to select transistor 115 and providing a negative voltage on first contact 107. This will reset the voltage of floating diffusion 105 to a predefined reference voltage Vref and will empty the storage well. Thereafter, controller 121 provides a logical low to transfer gate 106, first contact 107, and select transistor 115. This will start the integration time during which incoming light is converted into electron-hole pairs while keeping the floating node in reset mode. After the integration time, controller 121 provides a logical low to reset gate 113.

After a predetermined amount of time, controller 121 provides a logical high to select transistor 115. This will cause the voltage of floating diffusion 105 to be read out via source follower 104, select transistor 115, and column bus 116. The voltage V on column bus 116 can be represented as V = Vref - Vsel - Vreset, wherein Vsel is a small voltage drop associated with select transistor 115, and wherein Vreset is the reset noise voltage for charging the capacitance and the gate terminal of source follower 114. Voltage V is sampled by read out circuitry 122 and stored as voltage V1.

Now, controller 121 provides a logical high to transfer gate 106. This will cause the transfer of electrons from storage well 102 to floating diffusion 105. After a predetermined amount of time during this transfer period, a (negative) voltage is applied to first contact 107 to help reduce lag. After a predetermined amount of time, controller 121 provides a logical high to select transistor 115, and a logical low to first contact 107 and transfer gate 106. This will cause the voltage of floating diffusion 105 to be read out via source follower 104, select transistor 115, and column bus 116. The voltage V on column bus 116 can be represented as V = Vref - Vphoton - Vsel - Vreset, wherein Vphoton is the voltage difference directly attributed to the generation of electrons by incoming light. Voltage V is sampled by read out circuitry 122 and stored as voltage V2.

As a next step, the final voltage is computed as V2 - V1 = Vphoton. Accordingly, by using the CDS technique, the impact of any manufacturing process related variation of Vref and Vsel and especially Vreset on the final voltage, which may differ among different pixels, can be eliminated.

Figure 6 illustrates the energy profile of electrons during the transfer time. As can be observed, electrons in storage well SW experience a small energy barrier b when moving from storage well SW to floating diffusion FD via the channel formed underneath transfer gate TG. Despite the large energy difference dE between electrons in storage well SW and electrons in floating diffusion FD, a considerable amount of lag may result from energy barrier b. According to the invention, this problem is alleviated by providing a (negative) voltage to first contact 107. The application of this voltage will increase energy difference dE and/or reduce energy barrier b, both factors contributing to the reduction of lag.

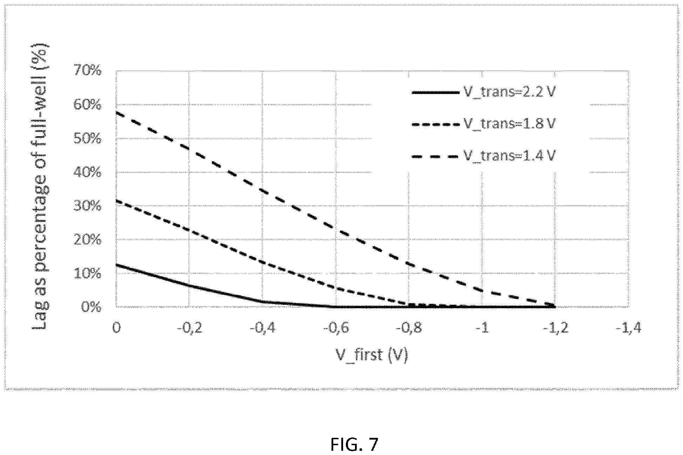

The effect of the first voltage can be observed from figure 7. Here, the lag is expressed as the amount of electrons left in the floating diffusion as a percentage of the maximum amount of electrons that can be in the floating diffusion (referred to as full-well) a predefined amount of time after initiation of the transfer. As shown, the amount of electrons can be reduced by increasing the voltage V_trans applied to the transfer gate. However, regardless of V _trans, a further reduction can be achieved by increasing the first voltage V_first.

Having a relatively low lag, enables the pixel to be used in sensors having a frame rate with a relatively high dynamic range.

In the description above, the present invention has been described using detailed embodiments thereof. However, the skilled person will readily appreciate that the invention is not limited to these embodiments but that various modifications can be made without departing from the scope of invention which is defined by the appended claims.

### REFERENCE SIGNS

- 100.: 4T pixel
- 101.: substrate
- 101A.: epitaxial layer
- 101B.: bulk semiconductor substrate
- 102.: storage well
- 103.: pinning layer
- 104.: pinned photodiode
- 105.: floating diffusion
- 106.: transfer gate
- 106A.: transfer gate contact
- 106B.: transfer gate oxide
- 107.: first contact
- 108.: isolation gate
- 108A.: isolation gate contact
- 108B.: isolation gate oxide
- 109.: diffusion region
- 110.: outer perimeter
- 111.: inner perimeter
- 112.: inner space
- 113.: reset transistor
- 114.: source follower
- 115.: select transistor
- 116.: column bus
- 117.: upper surface
- 118.: scintillator layer
- 120.: image sensor
- 121.: controller
- 122.: read-out circuitry
- 123.: control line
- 150.: 4T pixel
- 151.: isolating diffusion
- 200.: 4T pixel
- 201.: substrate
- 201A.: epitaxial layer
- 201B.: bulk semiconductor substrate
- 202.: storage well
- 203.: pinning layer
- 204.: pinned photodiode
- 205.: floating diffusion
- 206.: transfer gate
- 206A.: transfer gate contact
- 206B.: transfer gate oxide
- 207.: shallow trench isolation
- 213.: reset transistor
- 214.: source follower
- 215.: select transistor
- 216.: column bus
- 217.: upper surface
- FD.: floating diffusion
- SW.: storage well
- TG.: transfer gate

## Claims

1. A 4T pixel (100; 150), comprising:
a substrate (101) having arranged therein a storage well (102), a pinning layer (103), and a floating diffusion (105);
wherein the storage well, the pinning layer, and a part of the substrate that is adjacent to the storage well form a pinned photodiode (104), and wherein the floating diffusion is arranged spaced apart from the pinned photodiode;
a transfer gate (106) arranged in between the pinned photodiode and the floating diffusion;
wherein the pinned photodiode is configured to generate and store charge in response to incoming light during an integration time, and wherein the transfer gate is configured to allow the stored charge to transfer from the pinned photodiode to the floating diffusion during a transfer time;
wherein the pinning layer is electrically isolated from the substrate, the 4T pixel further comprising a first electrical contact (107) to the pinning layer that is configured for receiving a first voltage (V1) during at least part of the transfer time to increase a potential difference between the storage well and the floating diffusion;
wherein the pinning layer is electrically isolated from the substrate using an isolation gate (108) surrounding the pinning layer.

2. The 4T pixel (100) according to claim 1, further comprising a diffusion region (109) arranged spaced apart from the pinning layer, wherein the isolation gate is arranged in between the diffusion region and the pinning layer.

3. The 4T pixel (100) according to claim 2, wherein a doping type of the diffusion region is different from a doping type of the pinning layer; and/or wherein the diffusion region and/or the isolation gate are configured to be biased for generating a depletion region in between the diffusion region and pinning layer and substrate that prevents electrical contact between the substrate and pinning layer.

4. The 4T pixel (100; 150) according to any of the previous claims, wherein the pinning layer laterally extends beyond the storage well;
wherein the pinning layer preferably comprises an outer perimeter (110) and an inner perimeter (111), said inner perimeter defining an inner space (112) in which the transfer gate and floating diffusion are arranged, wherein the isolation gate or isolating diffusion completely surrounds the outer perimeter, and wherein the transfer gate is preferably arranged along the entire inner perimeter, and/or wherein the isolation gate or isolating diffusion is arranged along the entire outer perimeter.

5. The 4T pixel (100; 150) according to any of the previous claims, wherein the first contact forms an ohmic contact to the pinning layer, or wherein the first contact forms a Schottky contact to the pinning layer.

6. The 4T pixel (100; 150) according to any of the previous claims, wherein the substrate comprises an upper surface (117) on which the transfer gate and first contact are arranged;
the 4T pixel (100; 150) preferably further comprising a scintillator layer (118) arranged on the top surface of the substrate for converting incoming X-rays into visible light.

7. The 4T pixel (100; 150) according to any of the previous claims, wherein a doping type of the floating diffusion and a doping type of the storage well are identical, and wherein a doping type of the pinning layer and a doping type of the substrate are identical and different from the doping type of the floating diffusion layer and storage well;
wherein a doping type of the pinning layer is preferably p-type.

8. The 4T pixel (100; 150) according to any of the previous claims, wherein the substrate comprises a bulk semiconductor substrate and an epitaxial layer, wherein a doping type of the epitaxial layer is identical to the doping type of the pinning layer.

9. The 4T pixel (100; 150) according to any of the previous claims, further comprising:
a reset transistor (113) for resetting a voltage of the floating diffusion;
a source follower (114) connected to the floating diffusion; and
a select transistor (115) arranged to selectively connect an output of the source follower to a column bus (116).

10. The 4T pixel (100; 150) according to claim 9 in so far as depending on claim 4, wherein the reset transistor, select transistor and source follower are arranged within the inner space, and/or wherein at least one but preferably all of the reset transistor, source follower, and select transistor are formed using MOS transistors.

11. An image sensor (120), comprising:
a 4T pixel (100; 150) as defined in any of the claims 9-10;
a controller (121) for controlling the reset transistor, the select transistor, and transfer gate, and configured for applying a voltage to the first contact, wherein the controller is configured to:
control the reset transistor to reset a voltage of the floating diffusion;
control the transfer gate to allow charges in the storage well to transfer to the floating diffusion;
control the select transistor to allow a voltage of the floating diffusion to be read out via the column bus; and
apply a voltage to the first contact during at least part of said transfer time of charges;
wherein the controller is preferably further configured to control the select transistor, transfer gate and reset transistor to implement correlated double sampling.

12. The image sensor according to claim 11, comprising a plurality of said pixels arranged in a matrix of rows and columns, wherein pixels in the same column share the same column bus and wherein pixels in the same row are simultaneously controlled by the controller;
wherein the image sensor preferably further comprises read-out circuitry (122) for simultaneously collecting outputs from the plurality of column busses.

13. The image sensor according to any of the claims 11-12, wherein the controller is further configured to apply a voltage to the isolation gate;
wherein the controller is preferably further configured to operate the isolation gate in:
an isolating mode in which mode the voltage applied to the isolation gate results in a depletion region to form between the pinning layer and the substrate; and
an overflow mode in which mode the voltage applied to the isolation gate allows electrical contact between the storage well and the diffusion region depending on the filling of the pixel and the applied voltage on the isolation gate;
wherein the controller is preferably further configured to control a voltage applied to the diffusion region, preferably independently and separately from the voltage applied to the isolation gate.

## Patentansprüche

1. Ein 4T-Pixel (100; 150), aufweisend:
ein Substrat (101), in dem eine Speicherwanne (102), eine Pinning-Schicht (103) und ein potentialfreier Diffusionsbereich (105) angeordnet sind;
wobei die Speicherwanne, die Pinning-Schicht und ein Teil des an die Speicherwanne angrenzenden Substrats eine gepinnte Fotodiode (104) bilden, und wobei der potentialfreie Diffusionsbereich von der gepinnten Fotodiode beabstandet angeordnet ist;
ein Transfer-Gate (106), das zwischen der gepinnten Fotodiode und dem potentialfreien Diffusionsbereich angeordnet ist;
wobei die gepinnte Fotodiode so ausgebildet ist, dass sie während einer Integrationszeit, in Reaktion auf eintreffendes Licht, Ladung erzeugt und diese speichert, und wobei das Transfer-Gate so ausgebildet ist, dass es der gespeicherten Ladung ermöglicht, während einer Übertragungszeit von der gepinnten Fotodiode auf den potentialfreien Diffusionsbereich übertragen zu werden;
wobei die Pinning-Schicht von dem Substrat elektrisch isoliert ist, wobei das 4T-Pixel ferner einen ersten elektrischen Kontakt (107) zu der Pinning-Schicht aufweist, der so ausgebildet ist, dass er zumindest während eines Teils der Übertragungszeit eine erste Spannung (VI) empfängt, um zwischen der Speicherwanne und dem potentialfreien Diffusionsbereich eine Potentialdifferenz zu erhöhen;
wobei die Pinning-Schicht unter Verwendung eines die Pinning-Schicht umgebenden Isolations-Gates (108) von dem Substrat elektrisch isoliert ist.

2. Das 4T-Pixel (100) nach Anspruch 1, ferner aufweisend einen von der Pinning-Schicht beabstandet angeordneten Diffusionsbereich (109), wobei das Isolations-Gate zwischen dem Diffusionsbereich und der Pinning-Schicht angeordnet ist.

3. Das 4T-Pixel (100) nach Anspruch 2, wobei sich ein Dotierungstyp des Diffusionsbereichs von einem Dotierungstyp der Pinning-Schicht unterscheidet; und/oder wobei der Diffusionsbereich und/oder das Isolations-Gate so ausgebildet sind, dass sie eine Vorspannung aufweisen, um zwischen dem Diffusionsbereich und der Pinning-Schicht und dem Substrat einen Verarmungsbereich zu erzeugen, der einen elektrischen Kontakt zwischen dem Substrat und der Pinning-Schicht verhindert.

4. Das 4T-Pixel (100; 150) nach einem der vorherigen Ansprüche, wobei sich die Pinning-Schicht seitlich über die Speicherwanne hinaus erstreckt;
wobei die Pinning-Schicht vorzugsweise einen äußeren Umfang (110) und einen inneren Umfang (111) aufweist, wobei der innere Umfang einen inneren Raum (112) definiert, in dem das Transfer-Gate und der potentialfreie Diffusionsbereich angeordnet sind, wobei das Isolations-Gate oder der isolierende Diffusionsbereich den äußeren Umfang vollständig umgibt, und wobei das Transfer-Gate vorzugsweise entlang des gesamten inneren Umfangs angeordnet ist, und/oder wobei das Isolations-Gate oder der isolierende Diffusionsbereich entlang des gesamten äußeren Umfangs angeordnet ist.

5. Das 4T-Pixel (100; 150) nach einem der vorherigen Ansprüche, wobei der erste Kontakt einen ohmschen Kontakt mit der Pinning-Schicht bildet, oder wobei der erste Kontakt einen Schottky-Kontakt mit der Pinning-Schicht bildet.

6. Das 4T-Pixel (100; 150) nach einem der vorherigen Ansprüche, wobei das Substrat eine obere Fläche (117) aufweist, auf der das Transfer-Gate und der erste Kontakt angeordnet sind;
wobei das 4T-Pixel (100; 150) vorzugsweise ferner eine auf der oberen Fläche des Substrats angeordnete Szintillatorschicht (118) aufweist, um einfallende Röntgenstrahlen in sichtbares Licht umzuwandeln.

7. Das 4T-Pixel (100; 150) nach einem der vorherigen Ansprüche, wobei ein Dotierungstyp dem potentialfreien Diffusionsbereich und ein Dotierungstyp der Speicherwanne identisch sind, und
wobei ein Dotierungstyp der Pinning-Schicht und ein Dotierungstyp des Substrats identisch ist und sich von dem Dotierungstyp der potentialfreien Diffusionsbereich-Schicht und der Speicherwanne unterscheidet;
wobei ein Dotierungstyp der Pinning-Schicht vorzugsweise vom p-Typ ist.

8. Das 4T-Pixel (100; 150) nach einem der vorherigen Ansprüche, wobei das Substrat ein Bulk-Halbleitersubstrat und eine Epitaxial-Schicht umfasst, wobei ein Dotierungstyp der Epitaxial-Schicht mit dem Dotierungstyp der Pinning-Schicht identisch ist.

9. Das 4T-Pixel (100; 150) nach einem der vorherigen Ansprüche, ferner aufweisend:
einen Rücksetz-Transistor (113) zum Zurücksetzen einer Spannung des potentialfreien Diffusionsbereichs;
einen Source-Folger (114), der mit dem potentialfreien Diffusionsbereich verbunden ist; und
einen Auswahl-Transistor (115), der so angeordnet ist, dass er einen Ausgang des Source-Folgers selektiv mit einem Spaltenbus (116) verbindet.

10. Das 4T-Pixel (100; 150) nach Anspruch 9, insofern als dieser von Anspruch 4 abhängt,
wobei der Rücksetz-Transistor, der Auswahl-Transistor und der Source-Folger innerhalb des Innenraums angeordnet sind und/oder wobei zumindest eine der Komponenten Rücksetz-Transistor, Source-Folger und Auswahltransistor, vorzugsweise aber alle diese Komponenten, unter Verwendung von MOS-Transistoren gebildet sind.

11. Ein Bildsensor (120), aufweisend:
ein gemäß einem der Ansprüche 9 bis 10 definiertes 4T-Pixel (100; 150);
eine Steuerung (121) zum Steuern des Rücksetz-Transistors, des Auswahl-Transistors und des Transfer-Gates und ausgebildet zum Anlegen einer Spannung an den ersten Kontakt, wobei die Steuerung ausgebildet ist, um:
den Rücksetz-Transistor so zu steuern, dass eine Spannung des potentialfreien Diffusionsbereichs zurückgesetzt wird;
das Transfer-Gate so zu steuern, dass eine Übertragung von Ladungen in der Speicherwanne auf den potentialfreien Diffusionsbereich ermöglicht wird;
den Auswahl-Transistor so zu steuern, dass eine Spannung des potentialfreien Diffusionsbereichs über den Spaltenbus ausgelesen werden kann; und um
während zumindest eines Teils der Übertragungszeit von Ladungen an den ersten Kontakt eine Spannung anzulegen;
wobei die Steuerung vorzugsweise weiter so ausgebildet ist, dass sie den Auswahl-Transistor, das Transfer-Gate und den Rücksetz-Transistor so steuert, dass eine korrelierte Doppelabtastung implementiert wird.

12. Der Bildsensor nach Anspruch 11, aufweisend eine Mehrzahl der in einer Matrix aus Zeilen und Spalten angeordneten Pixel, wobei Pixel derselben Spalte gemeinsam denselben Spaltenbus nutzen, und wobei Pixel derselben Zeile von der Steuerung gleichzeitig angesteuert werden; wobei der Bildsensor vorzugsweise ferner eine Ausleseschaltung (122) aufweist, zum gleichzeitigen Erfassen der Ausgaben von der Mehrzahl an Spaltenbussen.

13. Der Bildsensor nach einem der Ansprüche 11 bis 12, wobei die Steuerung ferner so ausgebildet ist, dass sie an das Isolations-Gate eine Spannung anlegt;
wobei die Steuerung vorzugsweise ferner ausgebildet ist, um das Isolations-Gate so zu betreiben, dass:
in einem Isolationsmodus, die an das Isolations-Gate angelegte Spannung zur Bildung eines Verarmungsbereichs zwischen der Pinning-Schicht und dem Substrat führt; und
in einem Überlaufmodus, die an das Isolations-Gate angelegte Spannung, in Abhängigkeit von der Aufladung des Pixels und der an das Isolations-Gate angelegten Spannung, zwischen der Speicherwanne und dem Diffusionsbereich einen elektrischen Kontakt ermöglicht;
wobei die Steuerung vorzugsweise ferner so ausgebildet ist, dass sie eine an den Diffusionsbereich angelegte Spannung steuert, vorzugsweise unabhängig und getrennt von der an das Isolations-Gate angelegten Spannung.

## Revendications

1. Pixel à quatre transistors (4T) (100 ; 150), comprenant :
un substrat (101) dans lequel est agencé un puits de stockage (102), une couche de restriction (103) et une zone de diffusion flottante (105) ;
dans lequel le puits de stockage, la couche de restriction et une partie du substrat qui est adjacente au puits de stockage forment une photodiode pincée (104) et dans lequel la zone de diffusion flottante est agencée à l'écart de la photodiode pincée ;
une grille de transfert (106) agencée entre la photodiode pincée et la zone de diffusion flottante ;
dans lequel la photodiode pincée est configurée de manière à produire et stocker une charge en réponse à l'entrée de lumière au cours d'une période d'intégration et dans lequel la grille de transfert est configurée de manière à permettre le transfert de la charge stockée à partir de la photodiode pincée vers la zone de diffusion flottante au cours d'une période de transfert ;
dans lequel la couche de restriction est isolée électriquement du substrat, le pixel 4T comprenant, en outre, un premier contact électrique (107) sur la couche de restriction qui est configuré de manière à recevoir une première tension (V1) pendant au moins une partie de la période de transfert afin d'augmenter une différence de potentiel entre le puits de stockage et la zone de diffusion flottante ;
dans lequel la couche de restriction est isolée électriquement par rapport au substrat en utilisant une grille d'isolation (108) entourant la couche de restriction.

2. Pixel 4T (100) selon la revendication 1, comprenant, en outre, une zone de diffusion (109) agencée à l'écart de la couche de restriction, dans lequel la grille d'isolation est agencée entre la zone de diffusion et la couche de restriction.

3. Pixel 4T (100) selon la revendication 2, dans lequel un type de dopage de la zone de diffusion est différent d'un type de dopage de la couche de restriction ; et/ou dans lequel la zone de diffusion et/ou la grille d'isolation sont configurées de manière à être polarisées afin de produire une zone d'appauvrissement entre la zone de diffusion et la couche de restriction et le substrat qui empêche un contact électrique entre le substrat et la couche de restriction.

4. Pixel 4T (100 ; 150) selon l'une quelconque des revendications précédentes, dans lequel la couche de restriction s'étend latéralement au delà du puits de stockage ;
dans lequel la couche de restriction présente, de préférence, un périmètre externe (110) et un périmètre interne (111), ledit périmètre interne définissant un espace interne (112) dans lequel la grille de transfert et la zone de diffusion flottante sont agencées, dans lequel la grille d'isolation ou zone de diffusion isolante entoure entièrement le périmètre externe et dans lequel la grille de transfert est, de préférence, agencée suivant la totalité du périmètre interne, et/ou dans lequel la grille d'isolation ou zone de diffusion isolante est agencée le long de la totalité du périmètre externe.

5. Pixel 4T (100 ; 150) selon l'une quelconque des revendications précédentes, dans lequel le premier contact forme un contact ohmique sur la couche de restriction, ou dans lequel le premier contact forme un contact Schottky sur la couche de restriction.

6. Pixel 4T (100 ; 150) selon l'une quelconque des revendications précédentes, dans lequel le substrat comprend une surface supérieure (117) sur laquelle la grille de transfert et le premier contact sont agencés ;
le pixel 4T (100 ; 150) comprenant, en outre, de préférence, une couche d'élément de scintillation (118) agencée sur la surface supérieure du substrat afin de convertir des rayons X entrants en lumière visible.

7. Pixel 4T (100 ; 150) selon l'une quelconque des revendications précédentes, dans lequel un type de dopage de la zone de diffusion flottante et un type de dopage du puits de stockage sont identiques, et dans lequel un type de dopage de la couche de restriction et un type de dopage du substrat sont identiques et différents du type de dopage de la couche de diffusion flottante et du puits de stockage ;
dans lequel un type de dopage de la couche de restriction est, de préférence, du type p.

8. Pixel 4T (100 ; 150) selon l'une quelconque des revendications précédentes, dans lequel le substrat comprend un substrat semi-conducteur brut et une couche épitaxiale, dans lequel un type de dopage de la couche épitaxiale est identique au type de dopage de la couche de restriction.

9. Pixel 4T (100 ; 150) selon l'une quelconque des revendications précédentes, comprenant, en outre :
un transistor de réinitialisation (113) destiné à réinitialiser une tension de la zone de diffusion flottante ;
un élément suiveur de source (114) raccordé à la zone de diffusion flottante ; et
un transistor de sélection (115) agencé afin de raccorder sélectivement une sortie de l'élément suiveur de source à un bus de colonne (116).

10. Pixel 4T (100 ; 150) selon la revendication 9, dans la mesure où elle dépend de la revendication 4, dans lequel le transistor de réinitialisation, le transistor de sélection et l'élément suiveur de source sont agencés à l'intérieur de l'espace interne, et/ou dans lequel au moins un, mais, de préférence, la totalité des transistor de réinitialisation, élément suiveur de source et transistor de sélection sont formés en utilisant des transistors MOS.

11. Capteur d'image (120), comprenant :
un pixel 4T (100 ; 150) selon l'une quelconque des revendications 9 et 10 ;
une unité de commande (121) destinée à commander le transistor de réinitialisation, le transistor de sélection et la grille de transfert, et configurée de manière à appliquer une tension sur le premier contact, dans lequel l'unité de commande est configurée de manière à :
commander le transistor de réinitialisation de manière à réinitialiser une tension de la zone de diffusion flottante ;
commander la grille de transfert afin de permettre le transfert des charges dans le puits de stockage vers la zone de diffusion flottante ;
commander le transistor de sélection de manière à permettre la lecture d'une tension de la zone de diffusion flottante par l'intermédiaire du bus de colonne ; et
l'application d'une tension sur le premier contact pendant au moins une partie dudit temps de transfert de charge ;
dans lequel l'unité de commande est, en outre, de préférence, configurée de manière à commander le transistor de sélection, la grille de transfert et le transistor de réinitialisation afin de mettre en oeuvre un double échantillonnage corrélé.

12. Capteur d'image selon la revendication 11, comprenant une pluralité desdits pixel agencés en une matrice de rangées et de colonnes, dans lequel les pixels sur la même colonne partagent le même bus de colonne et dans lequel les pixels sur la même rangée sont commandés simultanément par l'unité de commande ;
dans lequel le capteur d'image comprend, en outre, de préférence, des circuits de lecture (122) afin de collecter simultanément des sorties à partir de la pluralité des bus de colonne.

13. Capteur d'image selon l'une quelconque des revendications 11 et 12, dans lequel l'unité de commande est, en outre, configurée de manière à appliquer une tension sur la grille d'isolation ;
dans lequel l'unité de commande est, en outre, de préférence, configurée de manière à agir sur la grille d'isolation dans :
un mode d'isolation, un mode dans lequel la tension appliquée sur la grille d'isolation conduit à la formation d'une zone d'appauvrissement entre la couche de restriction et le substrat ; et
un mode de débordement, un mode dans lequel la tension appliquée sur la grille d'isolation permet le contact électrique entre le puits de stockage et la zone de diffusion en fonction du remplissage du pixel et de la tension appliquée sur la grille d'isolation ;
dans lequel l'unité de commande est, en outre, de préférence, configurée de manière à commander une tension appliquée sur la zone de diffusion, de préférence, indépendamment et de manière distincte de la tension appliquée sur la grille d'isolation.
